Europäisches Patentamt

European Patent Office

Office européen des brevets

(19)

(11) **EP 0 752 759 A2**

(12) **EUROPÄISCHE PATENTANMELDUNG**

(43) Veröffentlichungstag:
08.01.1997 Patentblatt 1997/02

(51) Int. Cl.⁶: **H03K 19/017**

(21) Anmeldenummer: 96110333.0

(22) Anmeldetag: 26.06.1996

(84) Benannte Vertragsstaaten:
**AT DE FR GB IE IT NL**

(30) Priorität: **06.07.1995 DE 19524658**

(71) Anmelder: **SIEMENS AKTIENGESELLSCHAFT**
**80333 München (DE)**

(72) Erfinder: **Rieger, Johann, Dipl.-Ing.**
**93199 Zell (DE)**

(54) **Bootstrapschaltung**

(57) Bootstrapschaltung, die einen Transfertransistor (T1) aufweist, der mit einem Kanalanschluß mit dem Gate eines Treibertransistor (T2) verbunden ist. Am anderen Kanalanschluß des Transfertransistors (T1) ist ein erstes Signal (S1) anlegbar. An einem Kanalanschluß des Treibertransistors (T2) ist ein zweites Signal (S2) anlegbar, beispielsweise eine geboostete Wortleitungsspannung in einer Speicherzelle eines dynamischen Speichers, während sein anderer Kanalanschluß den Ausgang (OUT) der Bootstrapschaltung bildet. Der Pegel des dritten Signals (S3) weicht während der Vorladung des Gates des Treibertransistors (T2) von einem Vorladepegel (V) des ersten Signals (S1) um mindestens den Wert der Einsatzspannung des Transfertransistors (T1) ab. Auf diese Weise wird der Treibertransistor (T2) besonders weit aufgesteuert und eine Flanke des zweiten Signals (S2) sehr schnell an den Ausgang (OUT) übertragen.

FIG 1

EP 0 752 759 A2

**Beschreibung**

Die Erfindung betrifft eine Bootstrapschaltung.

Bereits bekannte Bootstrapschaltungen bestehen aus einem Transfertransistor, dessen einer Kanalanschluß mit dem Gate eines Treibertransistors vom selben Kanal-Typ verbunden ist. Sie werden beispielsweise in dynamischen Speichern (DRAMs) zur Schaltung von geboosteten Wortleitungsspannungen verwendet. Hierfür ist, sofern der Transfer- und der Treibertransistor vom n-Kanal-Typ sind, das Gate des Transfertransistors mit einem positiven Versorgungspotential verbunden. An einen Kanalanschluß des Treibertransistors ist dann ein Signal anlegbar, welches eine positive Flanke von 0 V auf einen geboosteten Spannungspegel, der großer als das Versorgungspotential am Gate des Transfertransistors ist, aufweist und welches über den Treibertransistor an dessen anderen Kanalanschluß, der den Ausgang der Bootstrapschaltung bildet, durchschaltbar ist. Hierzu wird an den anderen Kanalanschluß des Transfertransistors ein Signal mit einer positiven Flanke von 0 V auf den Wert des Versorgungspotentials angelegt, wobei diese Flanke vor derjenigen des am Treibertransistor anliegenden geboosteten Signals kommt. Dann wird nämlich das Gate des Treibertransistors über den Transfertransistor auf den Wert des Versorgungspotentials abzüglich der Einsatzspannung des Transfertransistors vorgeladen. Folgt dann die positive Flanke des geboosteten Signals, steigt das Potential am Gate des Treibertransistors aufgrund der kapazitiven Kopplung mit dem geboosteten Signal an, so daß sein Pegel immer über demjenigen des geboosteten Signales liegt. Als Folge dessen sperrt der Transfertransistor, und der Treibertransistor schaltet den vollen Pegel des geboosteten Signals an den Ausgang der Bootstrapschaltung durch.

Der Erfindung liegt die Aufgabe zugrunde, eine Bootstrapschaltung zu schaffen, mit der eine schnellere Durchschaltung des Signals am Treibertransistor möglich ist.

Diese Aufgabe wird mit einer Bootstrapschaltung gemäß Anspruch 1 gelost.

Weiterbildungen der Erfindung sind in den Unteransprüchen gekennzeichnet.

Die Erfindung bietet den Vorteil, daß das Gate des Treibertransistors auf ein Potential vorgeladen wird, welches nicht, wie beim Stand der Technik, vom Vorlade-Pegel des ersten Signals um den Wert der Einsatzspannung des Transfertransistors abweicht (beim Stand der Technik liegt am Gate des Transfertransistors ständig ein Potential mit dem Wert des Vorlade-Pegels des ersten Signals an, welcher gleich einem Versorgungspotential ist), sondern weist dem Vorlade-Pegel gegenüber eine geringere Differenz auf. Diese Differenz ist abhängig davon, um wieviel der Pegel des dritten Signals, betrachtet vom zweiten Pegel des zweiten Signals, diesseits des Vorlade-Pegels des ersten Signals liegt.

Optimal ist es, wenn diese Differenz mindestens dem Wert der Einsatzspannung des Transfertransistors entspricht. Dann wird nämlich der Vorlade-Pegel des ersten Signals vollständig vom Transfertransistor durchgeschaltet und das Gate des Treibertransistors entsprechend vorgeladen. In vorteilhafter Weise ergibt sich daraus eine größere Aufsteuerung des Treibertransistors, da der Betrag seiner Gate-Source-Spannung gegenüber dem Stand der Technik erhöht ist. Somit wird der zweite Pegel des zweiten Signals schneller an den Ausgang der Bootstrapschaltung durchgeschaltet. Folglich ergibt sich gegenüber dem Stand der Technik ein Geschwindigkeitsvorteil der erfindungsgemäßen Bootstrapschaltung.

Ein weiterer Vorteil der Erfindung ist, daß alternativ unter Beibehaltung der gleichen Durchschaltgeschwindigkeit für den zweiten Pegel des zweiten Signales der Treibertransistor kleiner dimensioniert werden kann (kleinere Kanalweite), wodurch eine merkliche Flächenersparnis für die Realisierung der Bootstrapschaltung erzielbar ist.

Bei einer Erhöhung des Betrags der Gate-Source-Spannung des Treibertransistors T2 von 2 V auf 3 V (= 2 V + angenommene Einsatzspannung des Transfertransistors T1 von 1 V) ergibt sich beispielsweise rechnerisch nach dem vereinfachenden Modell einer Langkanalnäherung

$$I_{Drain} = Const \cdot (U_{GS} - U_T)^2$$

eine um den Faktor vier größere Stromstärke $I_{Drain}$ durch den Treibertransistor T2 und damit eine vierfache Durchschaltgeschwindigkeit. Alternativ kann in diesem Fall bei gleicher Durchschaltgeschwindigkeit bzw. gleicher Stromstärke $I_{Drain}$ die Kanalweite um 3/4 reduziert werden. Für die Praxis kann ein Faktor zwei als realistisch angenommen werden.

Die Erfindung eignet sich insbesondere zur Anwendung in den Wortleitungstreibern von dynamischen Speichern (DRAMs).

Die Erfindung wird im folgenden anhand der Zeichnung näher erläutert. Es zeigen:

| Figur 1 | eine Schaltskizze der erfindungsgemäßen Bootstrapschaltung, |
|---|---|
| Figur 2 | den Verlauf der in Figur 1 bezeichneten Signale, |
| Figur 3 | den Verlauf der in Figur 1 bezeichneten Signale für den Fall, daß der Transfer- und der Treibertransistor vom p-Kanal-Typ sind, |
| Figuren 4a-c sowie 5a-c | die Schaltskizze und zugehörige Signalverlaufe je eines Ausführungsbeispiels eines Details der Figur 1. |

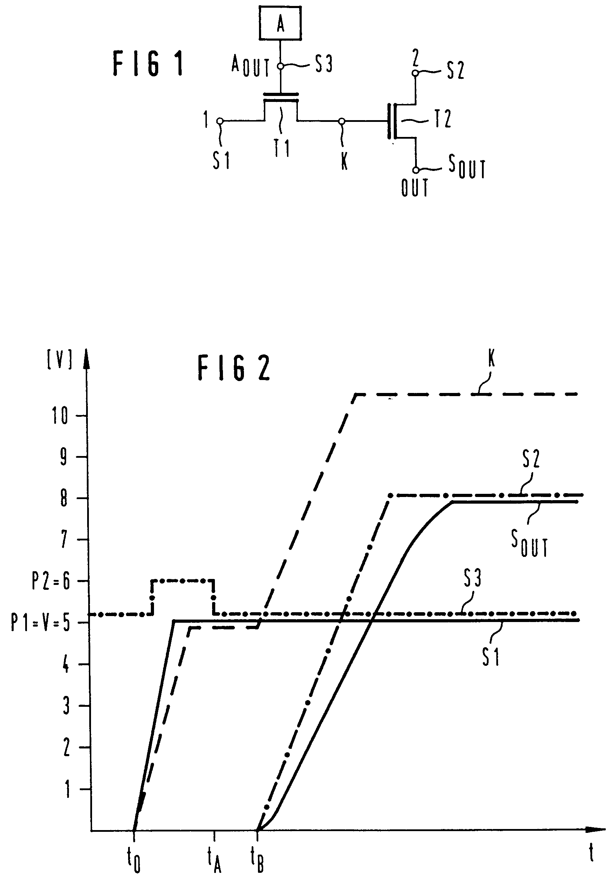

In Figur 1, die die erfindungsgemäße Bootstrapschaltung zeigt, sind ein Transfertransistor T1 und ein Treibertransistor T2 dargestellt, die beide vom n-Kanal-Typ sind. Bei anderen Ausführungsformen der Erfindung können diese beiden Transistoren T1, T2 auch vom p-Kanal-Typ sein. Der eine Kanalanschluß des Transfertransistors T1 ist mit dem Gate des Treibertransistors T2 verbunden. Der andere Kanalanschluß des Transfertransistors T1 ist mit einem ersten Signalanschluß 1 verbunden, an den ein erstes Signal S1 anlegbar ist. Der eine Kanalanschluß des Treibertransistors T2 ist mit einem zweiten Signalanschluß 2 verbunden, an den ein zweites Signal S2 anlegbar ist. Der andere Kanalanschluß des Treibertransistors T2 bildet den Ausgang OUT der Bootstrapschaltung, an dem sich ein Ausgangssignal SOUT einstellt. Das Gate des Transfertransistors T1 ist mit dem Ausgang AOUT einer Anordnung A verbunden, die zur Erzeugung eines dritten Signals S3 dient. Am Gate des Treibertransistors T2 stellt sich ein Gatesignal K ein.

Die Funktion der Bootstrapschaltung wird nun anhand der in Figur 2 dargestellten Signalverläufe für ein Ausführungsbeispiel der Erfindung erläutert.

Beginnend ganz links auf der Zeitachse, vor einem Zeitpunkt t0, haben bei diesem Ausführungsbeispiel alle Signale einen Pegel von 0 V mit Ausnahme des dritten Signals S3, welches einen ersten Pegel P1 von 5 V aufweist. Für dieses Ausführungsbeispiel wird angenommen, daß 5 V der Wert eines Versorgungspotentials einer integrierten Schaltung ist, deren Bestandteil die Bootstrapschaltung ist. Zum Zeitpunkt t0 beginnt eine positive Flanke des ersten Signals S1 auf einen Vorlade-Pegel V mit dem Wert des Versorgungspotentials von 5 V. Etwa gleichzeitig weist auch das dritte Signal S3 eine positive Flanke zu einem zweiten Pegel P2 mit einem Wert von 6 V auf, wobei dieser Potentialwechsel um 1 V angenommenermaßen mindestens gleich der Einsatzspannung des Transfertransistors T1 ist. Deshalb entspricht der High-Pegel des Gatesignals K dem Vorlade-Pegel V des ersten Signals S1, welcher bei diesem Ausführungsbeispiel gleich dessen High-Pegel ist.

Als Folge dessen steigt der Pegel des Gatesignals K ebenfalls auf 5 V an. Zu einem anderen Zeitpunkt tA fällt das dritte Signal S3 mit einer negativen Flanke wieder auf seinen ersten Pegel P1 von 5 V zurück. Nach diesem anderen Zeitpunkt tA bleibt das dritte Signal S3 auf dem Wert von 5 V. Es ist wichtig, daß sein Pegel denjenigen des Vorlade-Pegels V des ersten Signals S1 danach nicht mehr übersteigt. Nur dann ist sichergestellt, daß der Transfertransistor T1 für das Gatesignal K, dessen Pegel zum anderen Zeitpunkt tA gleich dem Vorlade-Pegel V ist, sperrt. Zu einem Bootstrap-Zeitpunkt tB folgt eine positive Flanke des zweiten Signals S2 auf eine geboostete Spannung von 8 V. Aufgrund der kapazitiven Gate-Source-Kopplung des Treibertransistors T2 und der bereits erfolgten Sperrung des Transfertransistors T1 steigt das Gatesignal K parallel zum zweiten Signal S2 auf einen Wert von etwa 9,5 V an.

Aufgrund der gegenüber dem Stand der Technik größeren Gate-Source-Spannung des Treibertransistors T2, die der Differenz der Potentiale des Gatesignals K und des zweiten Signals S2 entspricht, erfolgt eine schnellere Durchschaltung des letzteren, so daß am Ausgang OUT der Bootstrapschaltung das Ausgangssignal SOUT einen steilen Anstieg auf den Wert des zweiten Signals S2 (8 V) aufweist.

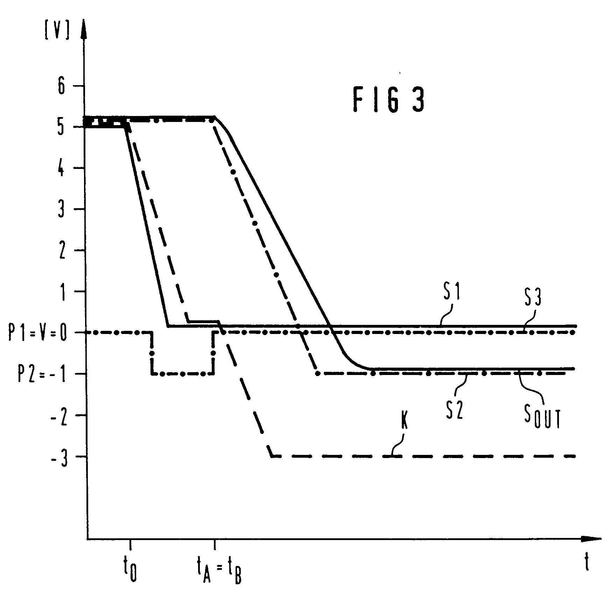

Figur 3 zeigt die Signalverläufe für den Fall, daß es sich beim Transfertransistor T1 und beim Treibertransistor T2 in Figur 1 nicht um Transistoren vom n-Kanal-Typ, sondern vom p-Kanal-Typ handelt. Für dieses Ausführungsbeispiel wird angenommen, daß vor einem Zeitpunkt t0 das dritte Signal S3 den ersten Pegel P1 mit einem Wert von 0 V aufweist, während alle übrigen Signale S1, S2, K, SOUT einen Wert von 5 V aufweisen.

Zum Zeitpunkt t0 erfolgt eine negative Flanke des ersten Signals S1 auf einen Wert von 0 V, der bei diesem Ausführungsbeispiel sein Vorlade-Pegel V ist. 0 V und 5 V können beispielsweise die Werte von Versorgungspotentialen der integrierten Schaltung sein, deren Bestandteil die Bootstrapschaltung ist. Etwa zeitgleich mit der negativen Flanke des ersten Signals S1 weist auch das dritte Signal S3 eine negative Flanke auf zu seinem zweiten Pegel P2 mit einem Wert von -1 V. Wiederum wird angenommen, daß dieser Potentialsprung um 1 V mindestens gleich der Einsatzspannung des Transfertransistors T1 ist. Hierdurch wird auch bei diesem Ausführungsbeispiel der Vorlade-Pegel V des ersten Signals S1 von 0 V vollständig an das Gate des Treibertransistors T2 durchgeschaltet (siehe Gatesignal K). Zum anderen Zeitpunkt tA, der bei diesem Ausführungsbeispiel gleich dem Bootstrap-Zeitpunkt tB ist, folgt eine positive Flanke des dritten Signals S3 zurück auf seinen ersten Pegel P1, so daß der Transfertransistor T1 sperrt. Gleichzeitig weist das zweite Signal S2 eine negative Flanke zu einem Wert von -1 V auf, der, wie beim Ausführungsbeispiel aus Figur 2, außerhalb des Potentialbereichs der Versorgungspotentiale von 0 V und 5 V liegt. Für das Gatesignal K ergibt sich eine negative Flanke und es wird mit dem Fallen des Pegels des zweiten Signals S2 immer negativer.

Das Ausgangssignal SOUT folgt aufgrund des größeren Betrages der Gate-Source-Spannung des Treibertransistors T2 wiederum schneller dem Verlauf des zweiten Signals S2, als es beim Stand der Technik der Fall ist.

Die angegebenen Potentialwerte sind nur beispielhaft. Bei anderen Ausführungsformen der Erfindung kann der Verlauf der Signale von den in den Figuren 2 und 3 dargestellten abweichen. Beispielsweise können alle Signale auch mehr als die dargestellten jeweils zwei Potentialpegel aufweisen. Das dritte Signal S3 in Figur 2 kann einen ersten Pegel P1 von 0 V statt der dargestellten 5 V aufweisen. Außerdem kann seine erste Flanke bei beiden Ausführungsbeispielen früher oder später als diejenige des ersten Signals S1 kommen. Kommt sie später, ergibt sich jedoch für das Gatesignal K eine flachere Flankensteilheit, so daß die Vorladung des Gates des Treibertransistors T2 nicht schnellstmöglich erfolgt. Je mehr während der Vorladung des Gates des Treibertransistors T2 der Pegel des dritten Signals S3 von demjenigen des ersten Signals S1 abweicht, desto schneller folgt das Gatesignal K dem ersten Signal S1.

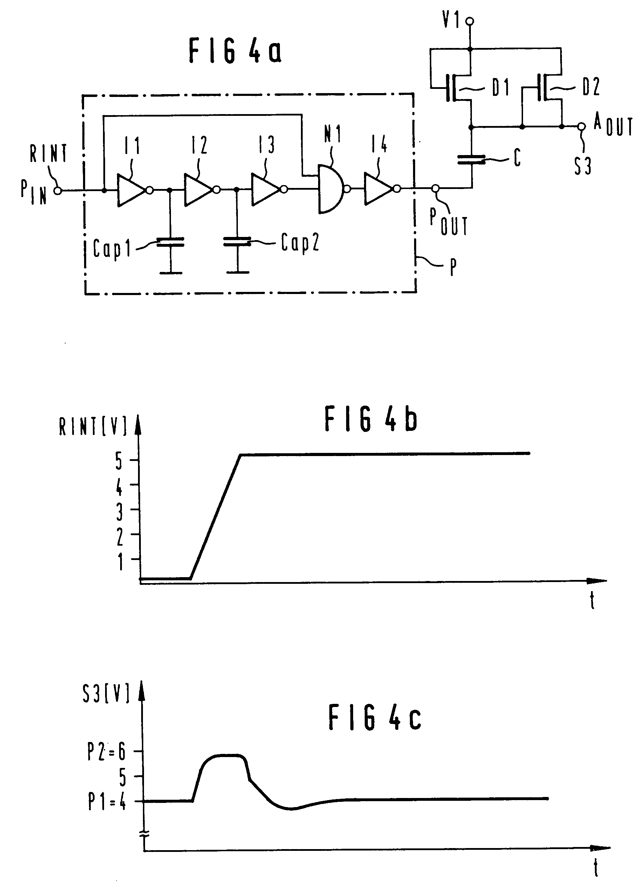

Figur 4a zeigt ein Ausführungsbeispiel der Anordnung A zur Erzeugung des dritten Signals S3 aus Figur 1, wenn der Transfertransistor T1 und der Treibertransistor T2 vom n-Kanal-Typ sind und das dritte Signal S3 eine Pulsform wie in Figur 2 aufweisen soll. Die eine Elektrode eines Kondensators C ist mit dem Ausgang AOUT der Anordnung A verbunden. Die zweite Elektrode des Kondensators C ist mit dem Ausgang POUT eines Pulserzeugers P verbunden, dem ein Steuersignal RINT über einen Eingang PIN zuführbar ist. Dieser Eingang PIN ist mit dem Ausgang POUT über einen ersten Inverter I1, einen zweiten Inverter I2, einen dritten Inverter I3, ein erstes NAND-Gatter N1 sowie einen vierter Inverter I4 verbunden. Ferner ist dieser Eingang PIN mit einem anderen Eingang des ersten NAND-Gatters N1 verbunden. Die Eingänge des zweiten Inverters I2 und des dritten Inverters I3 sind jeweils über einen Verzögerungskondensator Cap1, Cap2 mit Masse verbunden.

Die eine Elektrode des Kondensators C ist über einen als erste Diode D1 verbundenen n-Kanal-Transistor mit einem Versorgungspotentialanschluß V1 der integrierten Schaltung verbunden, an welchen ein positives Versorgungspotential von 5 V anlegbar ist. Die Diode D1 ist in Flußrichtung zwischen dem Versorgungspotentialanschluß V1 und der einen Elektrode des Kondensators C angeordnet, so daß diese nahezu auf den Wert des entsprechenden Versorgungspotentials vorladbar ist. Antiparallell zur ersten Diode D1 ist eine zweite Diode D2, ebenfalls durch einen n-Kanal-Transistor realisiert, angeordnet.

Am Eingang PIN des Pulserzeugers P ist ein Steuersignal RINT anlegbar, welches beispielsweise den in Figur 4b dargestellten Verlauf haben kann. Zunächst hat das Steuersignal RINT einen Wert von 0 V. Entsprechend ergibt sich am Ausgang AOUT der Anordnung A für den ersten Pegel P1 des dritten Signals S3 (Figur 4c) ein Wert, der um die Einsatzspannung der ersten Diode D1 unterhalb des Versorgungspotentials am Versorgungspotentialanschluß V1 liegt. Als Folge einer positiven Flanke des Steuersignals RINT auf 5 V erzeugt der Pulserzeuger P an seinem Ausgang POUT einen Potentialwechsel von einem ersten Potentialwert von 0 V auf einen zweiten Potentialwert von 5 V und, nach einer Verzögerung, die durch den ersten Inverter I1, den zweiten Inverter I2, den dritten Inverter I3 und die beiden Verzögerungskondensatoren Cap1, Cap2 verursacht wird, wieder zurück auf den ersten Potentialwert von 0 V. Hierdurch ergibt sich an der einen Elektrode des Kondensators C ein Potentialanstieg vom ersten Pegel P1 des dritten Signals S3 (4 V) auf seinen zweiten Pegel P2 (6 V) und anschließend wieder auf den ersten Pegel P1 (4 V). Der zweite Pegel P2 des dritten Signals S3 wird dabei durch die zweite Diode D2 auf den Wert des Versorgungspotentials zuzüglich der Einsatzspannung der zweiten Diode D2 begrenzt.

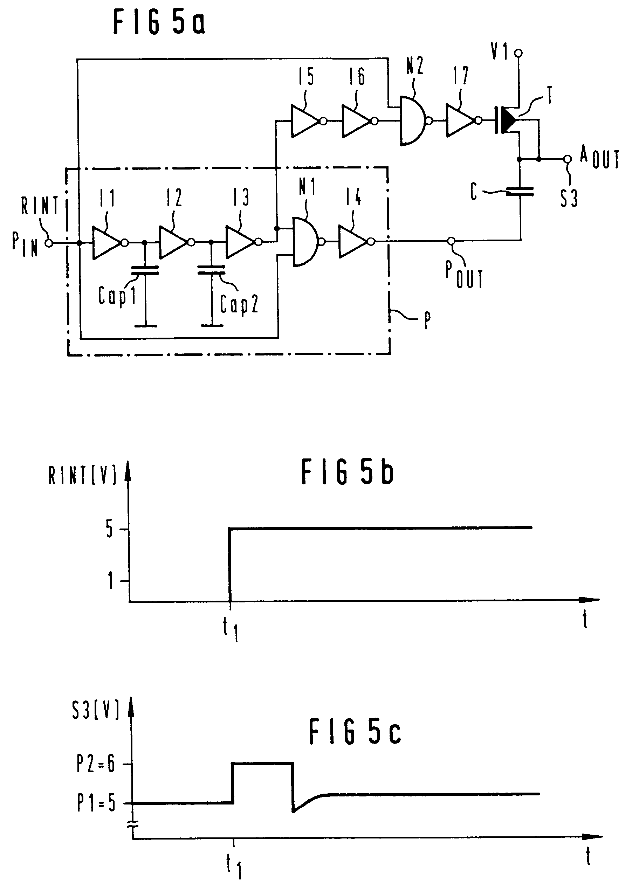

Figur 5a zeigt ein weiteres Ausführungsbeispiel für die Anordnung A aus Figur 1 (Transfertransistor T1 und Treibertransistor T2 vom n-Kanal-Typ). Statt der ersten Diode D1 und der zweiten Diode D2 weist dieses zwischen dem Versorgungspotentialanschluß V1 und der einen Elektrode des Kondensators C einen p-Kanal-Schalttransistor T3 auf, dessen Substratanschluß mit der einen Elektrode des Kondensators C verbunden ist. Zusätzlich zu derjenigen in Figur 4c weist die Anordnung A in Figur 5a zwischen dem Ausgang des dritten Inverters I3 und dem Gate des Schalttransistors T3 einen fünften Inverter I5, einen sechsten Inverter I6, ein zweites NAND-Gatter N2 sowie einen siebten Inverter I7 auf. Außerdem ist der Eingang PIN des Pulserzeugers P mit einem anderen Eingang des zweiten NAND-Gatters N2 verbunden.

Figur 5b und Figur 5c zeigen die Verläufe des Steuersignals RINT bzw. des dritten Signals S3.

Sind der Transfertransistor T1 und der Treibertransistor T2 in Figur 1 vom p-Kanal-Typ, kann das dritte Signal S3, welches dann einen negativen Puls (Figur 3) aufweist, mit einer ähnlichen Anordnung A wie in Figur 5a erzeugt werden. Hierzu muß der Schalttransistor T3 vom n-Kanal-Typ sein und an den Versorgungspotentialanschluß V1 ein Versorgungspotential von 0 V anlegbar sein.

**Patentansprüche**

1. Bootstrapschaltung mit folgenden Merkmalen:

   - der eine Kanalanschluß eines Transfertransistors (T1) ist mit dem Gate eines Treibertransistors (T2) vom selben Kanal-Typ verbunden,
   - der andere Kanalanschluß des Transfertransistors (T1) ist mit einem ersten Signalanschluß (1) verbunden, an den ein erstes Signal (S1) anlegbar ist,
   - der eine Kanalanschluß des Treibertransistors (T2) ist mit einem zweiten Signalanschluß (2) verbunden, an den ein zweites Signal (S2) anlegbar ist,
   - der andere Kanalanschluß des Treibertransistors (T2) bildet den Ausgang (OUT) der Bootstrapschaltung,
   - das Gate des Transfertransistors (T1) ist mit dem Ausgang (AOUT) einer Anordnung (A) verbunden, die zur Erzeugung eines dritten Signals (S3) dient,
   - das zweite Signal (S2) hat eine Flanke von einem ersten Pegel zu einem zweiten Pegel, die zu einem Bootstrap-Zeitpunkt (tB) beginnt,
   - spätestens zu einem anderen Zeitpunkt (tA), der spätestens gleich dem Bootstrap-Zeitpunkt (tB) ist, hat das erste Signal (S1) einen Vorlade-Pegel (V), der zwischen dem ersten und dem zweiten Pegel des zweiten Signals (S2) liegt,

- nach dem anderen Zeitpunkt (tA) hat das dritte Signal (S3) einen ersten Pegel (P1), der, betrachtet vom zweiten Pegel des zweiten Signals (S2), jenseits des Pegels des ersten Signals (S1) liegt oder diesem gleich ist,
- vor dem anderen Zeitpunkt (tA) hat das dritte Signal (S3) einen zweiten Pegel (P2), der, betrachtet vom zweiten Pegel des zweiten Signals (S2), diesseits des Vorlade-Pegels (V) des ersten Signals (S1) liegt.

2. Bootstrapschaltung nach Anspruch 1,
**dadurch gekennzeichnet,**
daß vor dem anderen Zeitpunkt (tA) der Pegel des dritten Signals (S3) von demjenigen des ersten Signals (S1) um mindestens den Wert der Einsatzspannung des Transfertransistors (T1) abweicht.

3. Bootstrapschaltung nach einem der vorstehenden Ansprüche,
**dadurch gekennzeichnet,**
daß das dritte Signal (S3) ein Pulssignal ist.

4. Bootstrapschaltung nach Anspruch 3,
**dadurch gekennzeichnet,**
daß das erste Signal (S1) vor dem Erreichen des Vorlade-Pegels (V) eine Flanke aufweist und daß das dritte Signal (S3) bereits vor dieser Flanke, betrachtet vom zweiten Pegel des zweiten Signals (S2), diesseits des Vorlade-Pegels (V) des ersten Signals (S1) liegt.

5. Bootstrapschaltung nach einem der Ansprüche 3 oder 4,
**dadurch gekennzeichnet,**
daß die Anordnung (A) folgende Merkmale aufweist:

- die eine Elektrode eines Kondensators (C) ist mit dem Ausgang (AOUT) der Anordnung (A) verbunden und auf den ersten Pegel (P1) des dritten Signales (S3) vorladbar,
- die zweite Elektrode des Kondensators (C) ist mit dem Ausgang (POUT) eines Pulserzeugers (P) verbunden, dem ein Steuersignal (RINT) über einen Eingang (PIN) zuführbar ist,
- als Folge einer Flanke des Steuersignals (RINT) ist mittels des Pulserzeugers (P) an seinem Ausgang (POUT) ein Potentialwechsel von einem ersten Potentialwert zu einem zweiten Potentialwert und wieder zum ersten Potentialwert erzeugbar, so daß eine Potentialverschiebung an der ersten Elektrode des Kondensators (C) vom ersten Pegel (P1) des dritten Signals (S3) zu seinem zweiten Pegel (P2) und wieder zum ersten Pegel (P1) erfolgt.

6. Bootstrapschaltung nach Anspruch 5,
**dadurch gekennzeichnet,**
daß die erste Elektrode des Kondensators (C) zur Vorladung auf den ersten Pegel (P1) des dritten Signals (S3) über eine erste Diode (D1) mit einem Versorgungspotentialanschluß (V1) verbunden ist.

7. Bootstrapschaltung nach Anspruch 6,
**dadurch gekennzeichnet,**
daß zur Begrenzung des zweiten Pegels (P2) des dritten Signals (S3) eine zweite Diode (D2) zwischen der ersten Elektrode des Kondensators (C) und dem Versorgungspotentialanschluß (V1) vorgesehen ist, die antiparallel zur ersten Diode (D1) geschaltet ist.

8. Bootstrapschaltung nach Anspruch 5,
**dadurch gekennzeichnet,**
daß die erste Elektrode des Kondensators (C) zur Vorladung auf den ersten Pegel (P1) des dritten Signals (S3) über die Kanalstrecke eines Schalttransistors (T3) mit einem Versorgungspotentialanschluß (V1) verbunden ist,
daß der Schalttransistor (T3) im wesentlichen gleichzeitig mit dem Anliegen des zweiten Potentialwertes am Ausgang (POUT) des Pulserzeugers (P) sperrbar ist
und daß der Schalttransistor (T3) nach dem erneuten Wechsel zum ersten Potentialwert am Ausgang (POUT) des Pulserzeugers (P) zuzüglich einer weiteren Verzögerung wieder öffenbar ist.

9. Bootstrapschaltung nach einem der vorstehenden Ansprüche,
**dadurch gekennzeichnet,**
daß sie Bestandteil einer integrierten Speicherschaltung ist, daß das erste Signal (S1) das Ausgangssignal eines Wortleitungs-Dekodierers ist und daß das zweite Signal (S2) eine geboostete Wortleitungsspannung ist.

10. Bootstrapschaltung nach Anspruch 9,
**dadurch gekennzeichnet,**
daß das Steuersignal (RINT) ein internes Row-Address-Strobe-Signal ist, das aus einem extern an die integrierte Schaltung anlegbaren Row Address Strobe-Signal ableitbar ist.

FIG 1

FIG 2

FIG 3

# FIG 4a

# FIG 4b

# FIG 4c

# FIG 5a

# FIG 5b

# FIG 5c